# EUROPEAN PATENT SPECIFICATION

(11) **EP 2 795 200 B1**
(45) Date of publication and mention of the grant of the patent: **19.10.2016**
(21) Application number: 12818562.6
(22) Date of filing: 30.11.2012
(51) Int. Cl.: F24H 9/20, G01R 31/28, H05B 1/02

(54) **METHOD AND MEANS FOR CONTROLLING THE INTEGRITY OF AN ELECTRIC RESISTANCE**
VERFAHREN UND MITTEL ZUR STEUERUNG DER INTEGRITÄT EINES ELEKTRISCHEN WIDERSTANDS
PROCÉDÉS ET MOYENS PERMETTANT DE CONTRÔLER L'INTÉGRITÉ D'UNE RÉSISTANCE ÉLECTRIQUE

(30) Priority: 22.12.2011 IT AN20110168
(43) Date of publication of application: 29.10.2014
(73) Proprietor: Thermowatt S.p.A., 60011 Arcevia (Ancona) (IT)
(72) Inventor: CAPITANELLI, Claudio, 60011 Arcevia (Ancona) (IT)
(74) Representative: Premru, Rok
(86) International application number: PCT/IB2012/002571
(87) International publication number: WO 2013/093583

(56) References cited:
- DE-A1- 19 940 988
- GB-A- 1 599 891
- US-A- 3 524 966

## Description

### DESCRIPTION

The object of the present invention is a simple and reliable device for instantly detecting the deterioration of the electrical insulation of electrical immersion resistances for water heating.

The invention therefore falls within the field of water heating elements, in particular for electric storage water heaters, but more in general, for any household appliance, such as dishwashers and washing machines, which uses immersion heating elements or still, for water heaters in baths, still of the immersion type.

The so-called armoured electric resistances are mainly used in this kind of appliances. They comprise a resistive electric filament coaxial to a metal tube (the actual armour) wherefrom it is kept separate, the electric filament being immersed in an electrically insulating and chemically inert powder (usually magnesium oxide powder).

During the insertion of the powder, which takes place by gravity, between armour and electric filament kept vertical, the armour is subject to vibration for a better compaction of the same powder.

As per prior art, the tube constituting the resistance armour is of metal material; copper alloys were often used in the past while aluminium, stainless steel and titanium alloys are also used currently, as they are less subject to corrosion by galvanic effect in the metal tanks for storing the heated water.

After having been inserted between armour and electric filament, the magnesium oxide powder is compacted with known techniques, for example by hammering or rolling.

The resistance is then sealed at the ends impregnating the insulating powder with suitable sealing resins in order to prevent the escape of the same powder and the entrance of humidity; a connector is then placed on each end of the resistance (for example a "faston" connector) for the connection to respective electric supply means; finally, the rectilinear resistance thus obtained is bent and/or wound to impart the desired final shape, even complex (such as U, zigzag, spiral-wise, etc.) thereto.

Hereinafter, for convenience of description, the electric immersion heating elements mentioned above, with a single electric insulation status, will be generically referred to with the term of "standard armoured resistance".

By now, the standard armoured resistance is made with standardised materials and technologies, providing an appreciable guarantee of good operation; however, it is not free from drawbacks, the greatest of which of course lies in the possibility of piercing of the armour and of the insulating material or in any case in the absorption of humidity by the magnesium oxide powder due to an imperfect application of the sealer, with consequent risk of short-circuit between the resistive filament and the water wherein the resistance is immersed.

In fact, a breakage of the armour allows the water contained in the tank to contact the resistive filament, so that the water and all the electrically conductive parts connected thereto are live.

On the other hand, given the production process, there are no alternatives to the use of a powder, having to use a material not just easily compactable but also suitable for the direct contact with the electric filament: in fact, the latter reaches temperatures of some hundreds degrees during operation.

If the safety rules are observed both in the construction of the water heater and in the making of the electric supply system, the breakage of the outer armour should cause no hazardous situations for the user. In fact all the metal parts of the water heater, as well as the electric system, have a ground connection, and a cut-out box is further provided.

However, the safety rules are not always observed. It may happen that the electric system is negligently not provided with ground or, as it happens in some Countries, the cut-out box is not provided.

A partial solution to this type of problems has been reached by making immersion electric resistances provided with a dual electric insulation layer which therefore greatly reduce the likelihood of short-circuits.

Chinese patent No. CN 201298931Y describes an example of this type of electric resistance with dual electric insulation: a typical standard armoured resistance is further added with a second insulating layer of magnesium oxide and an outer metal tube which encloses the assembly.

Also the second layer is in any case subject to risks of entrance of humidity due to flaws in the resin sealing.

In such Chinese document CN 201298931 Y there are provided no control means for checking the regular operation of the electric resistance, i.e. for monitoring the wear condition thereof and preventing risks for the user in case of piercing and short-circuit between the resistive element and the storage water.

JP 7208805, which also refers to an armoured resistance provided with multiple insulating layers, indicates means for checking their integrity. A device is provided which measures the electric resistance of the outermost armour of the inner resistive filament.

Therefore, such measurement cannot be actuated but with the resistive filament disconnected from the electric power supply network; this requires means for disconnecting the electric resistance and thus, necessarily, such monitoring cannot occur continuously but at time intervals. The document indicates 24 h intervals. At each measurement, the difference between the resistance value measured and a stored one is assessed; the resistance is regarded as faulty if such difference exceeds a predetermined threshold. The indicated method can therefore signal slow degradations in the insulating value but cannot protect from sudden faults; the measurement procedure, moreover, is more complex than what should be allowed to a safety device wherein simplicity is one of the best guarantees for reliability.

Similar to document JP 7208805, also German patent DE 19940988 provides a method for controlling the integrity of one or more insulating layers of an electric resistance, mandatorily after disconnecting both the terminals thereof from the mains.

Document DE 199409855, the described system whereof is also applicable to single insulation resistances, measures the electric filament resistivity; also in this document there is provided, by means of test diverters, the disconnection of the resistance terminals from the mains and the connection thereof to an instrument for measuring the resistance resistivity: if this is too high, it means that the resistance is interrupted; if it is too low, there is a short-circuit through the insulating layer. Of course, what is important is the possibility of determining the presence of short-circuits; on the other hand, detecting the resistance disconnection is not significant since it is not related to hazard situations; moreover, such fault is of course already signalled by the failed heating of the resistance.

Therefore, such methods cannot carry out a continuous monitoring, requiring the periodical deactivation of the electric resistance; moreover, they require expensive additional devices, such as the test diverters and the measurement instrument for checking the integrity of the insulating layer; finally, they are designed especially for single insulation resistances.

Hereinafter, the electric immersion heating elements with two or more concentric insulating layers, each of which, from the inside outwards, confined in a corresponding metal sheath, shall be generically referred to with the term "multiple insulation resistance". Of course, in most practical cases, such multiple insulation resistances shall simply consist of dual insulation resistances.

While such multiple insulation resistances represent an advance in safety, however it has been seen that the means and the methods indicated for monitoring the integrity thereof are not yet satisfactory.

An object of the present invention is to at least partly obviate such drawbacks by providing continuous monitoring devices and methods which, upon the occurrence of a degradation of one or more layers of the electric insulation of a multiple insulation resistance, immediately emit a signal usable for alerting the user and/or automatically disconnecting the same resistance from the mains.

A further object, at least of some of the variants of the present invention, is to use, for said disconnection from the mains, devices already present or already provided for controlling said multiple insulation resistance.

A further object, at least for the preferred variants of the present invention, is to achieve the above objects also in the absence of mains power or with deactivated electric resistance.

These and other objects, which shall clearly appear hereinafter, are achieved with the device according to the invention, the features whereof shall appear more clearly from the following description of preferred embodiments thereof, according to the patent claims and illustrated, by way of a non-limiting example, in the annexed drawings, wherein:
- figure 1 schematically shows a dual insulation resistance and an alarm circuit in the event of degradation of the electric insulation of the outermost insulating layer;
- figure 2 schematically shows a dual insulation resistance and an alarm and tripping circuit in the event of degradation of the electric insulation of the outermost insulating layer according to a first variant;
- figure 3 schematically shows a dual insulation resistance and an alarm and tripping circuit in the event of degradation of the electric insulation of the outermost insulating layer according to a second variant;
- figure 4 schematically shows a dual insulation resistance and an alarm and tripping circuit in the event of degradation of the electric insulation of the outermost insulating layer according to a third variant.

The features of the invention are now described using the references in the figures.

With reference to all the figures, reference numeral 10 indicates a dual insulation resistance whereon the description of the invention shall be based, which shall then be generalised to a multiple insulation resistance 10.

In the different variants, letter C indicates the device for controlling the integrity of the outer insulating layer of a dual insulation resistance 10.

Reference numeral 22 indicates a low voltage current generator consisting of an accumulator kept charged by a power supply or, preferably, of a simple battery for its very low cost and for the fact that, in open circuits, it lasts for years. A power supply directly supplied from the mains would at least have the drawback of not operating in the absence of electric energy from the mains. However, it is also possible to provide for said low voltage current generator 22 to be a common transformer apt to modify the voltage of the current coming from the mains.

Reference numeral 21 indicates a monostable button electric switch, capable of closing the electric circuit only when pressed (hereinafter referred to as "test switch 21").

Reference numeral 23, depicted with the symbol used for the LED, indicates a sound or visual signaller (hereinafter "signaller 23"), that is, a signalling device such as a buzzer or a LED that can emit sound or light signals perceivable by a user.

Reference numeral 24 indicates possible resistors for calibrating the current and the voltage drop allowed at the terminals of signallers 23 (hereinafter "calibration resistors 24") in the electric circuits 20.a, 20.b, 20.c, 20.d illustrated hereinafter.

Letters A and B indicate connection points of said electric circuits 20.a, 20.b, 20.c, 20.d., respectively to the outer sheath 11 and to the inner sheath 12 of the dual insulation resistance 10.

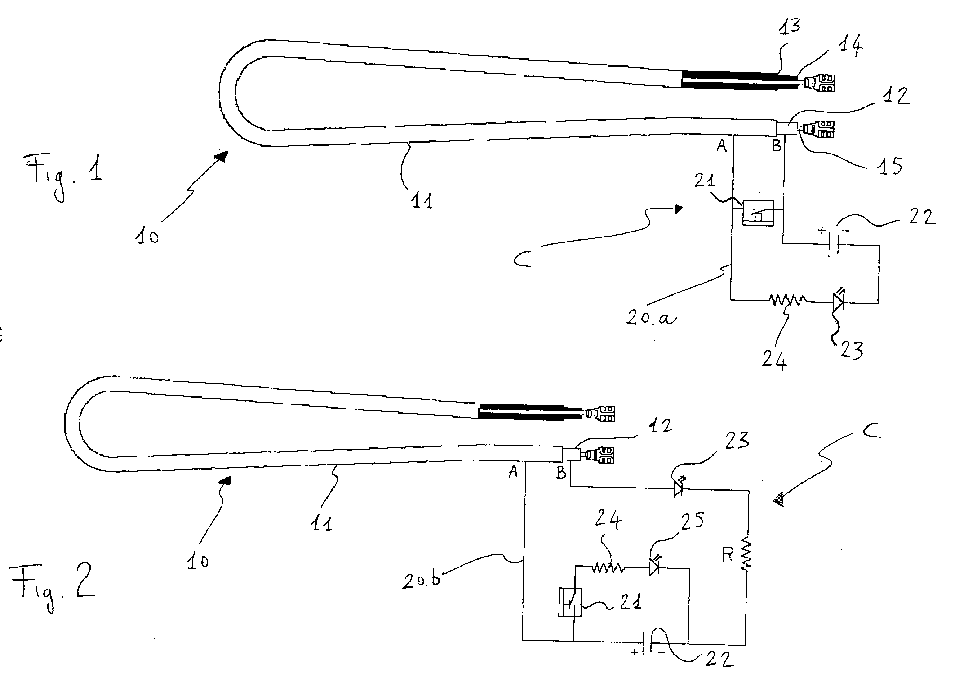

With reference to figure 1, the current generator 22 applies a voltage differential between said outermost 11 and innermost 12 sheaths but since they are electrically insulated from each other from the outermost insulation layer 13, this does not produce current circulation.

The voltage and power of the current generator 22 are those sufficient for energising signaller 23 and the other means that shall be illustrated hereinafter, which only occurs in the case of degradation of the dielectric power of the outermost insulation layer 13, sufficient for allowing the passage of a short-circuit current Icc necessary for such energisation.

It is known that signallers 23 of this type are energised under voltages much weaker than hazardous values, in the range of 2 - 3 V, therefore, the voltage applied by said one current generator 22 can be within such size range.

Thanks to circuit 20.a of fig. 1, all the elements whereof have been indicated, because a voltage is constantly applied at the connection points A and B, there is a continuous monitoring of the status of the outer insulation layer 13 and as soon as its resistance value drops due to a loss of dielectric power, a short-circuit current Icc generates in circuit 20.a, subsequent whereto signaller 23 emits an alarm signal perceivable by the user.

At this point, however, it is suitable to periodically test the charging status of such accumulator or battery 22 or, in any case, to check the efficiency of the generic current generator 22 and/or the integrity of at least part of circuit 20.a. This is obtained by providing the test switch 21 which, if pressed, allows the energisation of signaller 23 provided that the current generator 22 is efficient and circuit 20.a intact. The same device may be provided in the subsequent circuits 20.b, 20.c, 20.d that shall be illustrated.

Therefore, in circuit 20.a, signaller 23 has a dual function:
- main one, i.e. signalling the status of the outer insulation layer 13;
- secondary one, i.e. signalling the charge status of such accumulator or battery 22 and the integrity of circuit 20.a.

It is known that in most water heater thermostats there is a thermal-protection device provided with a thermal-sensitive element substantially consisting of a bistable bimetallic disc which, if led to temperatures higher than a certain threshold and indicative of malfunction in the heat-regulating thermostat, trips, inverting the camber thereof, and in this way it irreversibly opens both electric contacts that connect the electric heating element to the mains.

Less frequent but yet used, are other types of thermal protectors (e.g. wherein the thermal-sensitive elements are fuses) which, while based on other principles, act all together when the thermal-sensitive elements reach temperatures higher than a predetermined value. The feature that such thermal protectors share is that the thermal-sensitive elements also serve as actuators, meaning that it is a mechanical modification thereof, caused by the variation temperature that causes the opening of the electric resistance contacts. Such thermal protectors shall hereinafter referred to as "electro-mechanical thermal protectors".

If the dual insulation resistance 10 serves an appliance such as a water heater or the like, provided with such type of thermal protector, then it is advantageously possible to use the variant of the invention shown in fig. 2, in circuit 20.b whereof there are provided all the elements already indicated in circuit 20.a and in addition, one or more resistors R having few W power (preferably from 2 to 6 W).

Such resistors R are arranged in close vicinity with the thermal sensitive elements of the electro-mechanical thermal protector (not shown), so that if circuit 20.b closes due to a loss of dielectric power of the outer insulation layer 13, the short-circuit current Icc circulating is sufficient for heating such thermal sensitive elements up to the tripping of the thermal protector. Given the very low electric power required, such resistors R are very small sized and can be easily seated outside and/or inside the same container seating the thermal sensitive elements.

In other words, in this variant of the invention a current signal, indicative of a degradation of the electric insulation, is transformed into a temperature signal so as to make, in the event of a failure, a safety device trip, which is in any case provided in the water heater but designed to protect from heating rather than from electric insulation anomalies.

Circuit 20.b may have been designed as circuit 20.a unless resistors R have been added in series with signaller 23 which, as with circuit 20.a, may have kept the dual function of signaller of the status of insulator 13 and of the charge of generator 22.

However, a preferred variant is that actually shown in fig. 2 where a further signaller 23 has been added, arranged on a circuit parallel to that of resistors R and in series with the test switch 21.

The reason is that when the test switch 21 is used for checking the charge status of battery 22, if resistors R were in series with the same switch 21, especially if pressing the button thereof was a little delayed, said resistors R may heat to the point of causing the tripping of the thermal protector, thus requiring the intervention of the Technical Support Service for the reset.

On the contrary, since circuit 20.b is provided with an active safety, the signaller 23 therein is only preferred but not essential for the fundamental objects of the invention. Likewise, such signaller 23 is not essential in the subsequent circuits 20.c and 20.d.

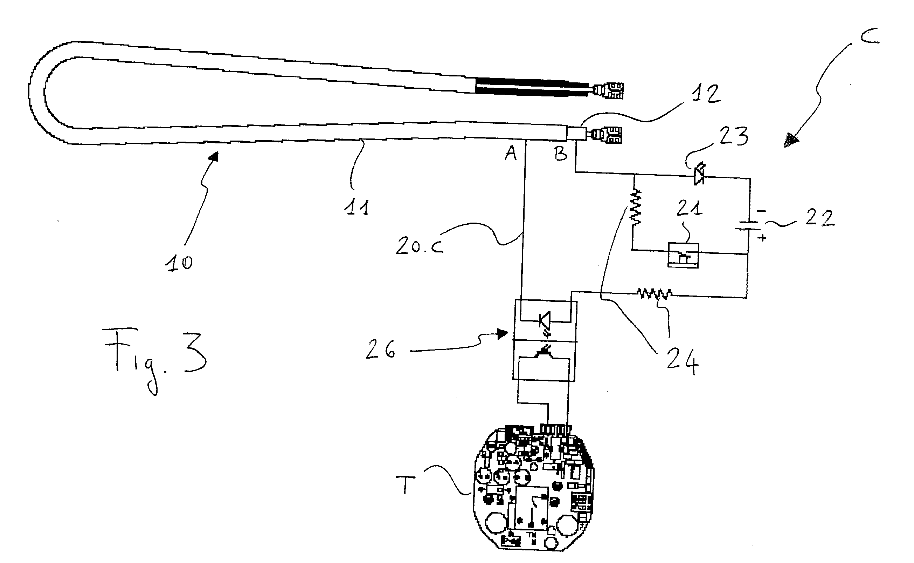

Coming to the variant of fig. 3, it shows an electronic thermostat T provided with non electro-mechanic thermal protector. In fact, in such types of thermostats, the thermal protector (hereinafter referred to as "electronic thermal protector") frequently trips subsequent to a signal of a temperature probe immersed in the hot water checked.

Circuit 20.c is provided with an optical insulator 26 by means of which the short-circuit current signal Icc that generates at the beginning of the dielectric power degradation is transmitted to an electronic thermostat T with electronic thermal protector. The LED of the optical insulator 26 is preferably lighted directly by the short-circuit current Icc circulating in circuit 20.c. The photocell of the same optical insulator 26 is connected to contacts generally already present in such electronic thermostats T. In this way, a signal is sent to thermostat T which produces the same effect as said temperature probe, i.e. the tripping of the electronic thermal protector is caused.

Also for the LED of the optical insulator 26, if directly crossed by the short-circuit current Icc, it may be necessary to provide a calibration resistor 24 in series.

The optical insulator 26 may be replaced by any other transmission means energisable by the short-circuit current Icc and compatible with an electronic thermostat T.

Of course, the activation of the electronic thermal protector is only possible in the presence of mains voltage, but this is an implicit limit in electronic thermal protectors, not in the invention (it is also true that the resistance is not active in the absence of mains supply voltage).

In any case, the LED of the optical insulator 26 remains lighted until the charge of the current generator 22 lasts, which may be assessed in a month, and therefore the electronic thermal protector may be activated as soon as the main voltage is restored.

As shown, also such circuit, moreover, may be provided with a signaller 23 which may have the dual function of signalling the status of the outer insulation layer 13 and the charge status of the accumulator or battery 22. Such signaller, as already noted, is also active in the absence of mains power supply.

There are uses of the dual insulation resistances 10 wherein an electro-mechanical or electronic thermal protector is not required; this is the case of resistances used for heating water in open containers (such as for example the direct heating of water in baths).

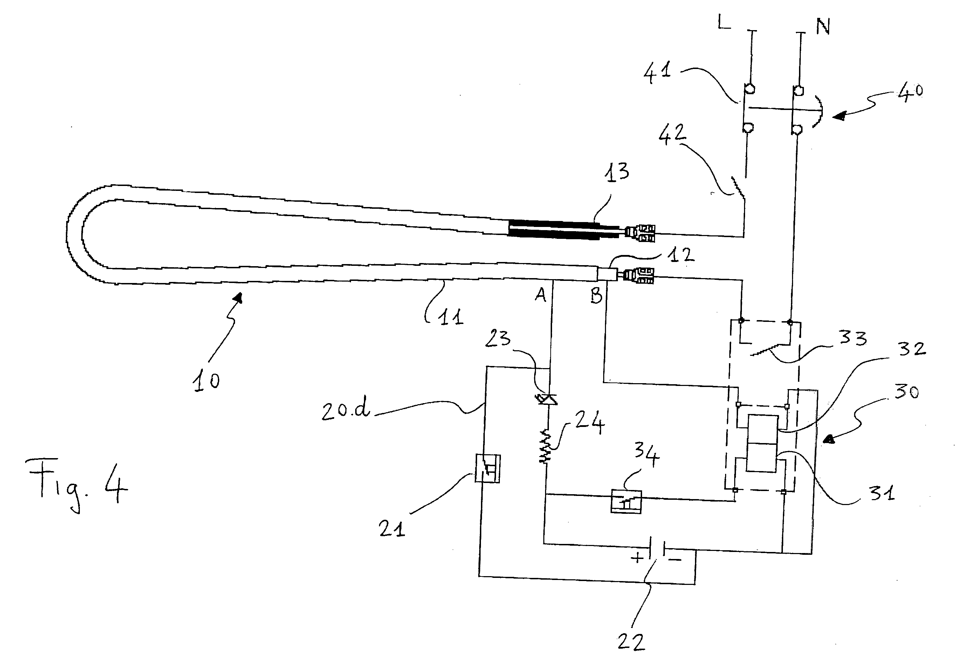

Coming now to fig. 4, circuit 20.d shows a device for disconnecting the dual insulation resistance 10 which does not use pre-existent electro-mechanical or electronic thermal protectors.

The figure also shows, but only for highlighting that it is unrelated to the invention, a possible thermostat 40 provided with dual safety switch 41 and with single adjustment switch 42.

In addition to the already described current generator 22, test switch 21 and signaller 23 with the already mentioned dual function for the status of the insulation layer 13 and of charge of the accumulator or battery 22, circuit 20.d is provided with a bistable relay switch 30 with first and second coil 31 and 32 which open/close switch 33.

At first, switch 33 is closed by the device's manufacturer by pressing the button of the reset switch 34 which energises the first coil 31; such reset switch 34 is preferably placed in a position not accessible by the user and, for the purposes of the invention, it may be regarded as a part of the bistable relay 30.

A normal operation is allowed to the dual insulation resistance 10, piloted by the optional thermostat 40, whatever its type.

In the case of degradation of the dielectric capacity of the resistance of the outer insulation layer 13, current circulates in circuit [A - B - 32 - 22 - 24 - 23 - A] and coil 32 is energised, which opens switch 33.

For graphical clarity reasons, the figure shows a bistable relay 30 which only opens one of the poles connected to the dual insulation resistance 10, but it is clear that with a bistable relay 30 and/or with two bistable relays it is possible to open both poles, as it is mandatory for the thermal protectors.

Again for graphical clarity reasons, all of the switch contacts are shows as open while their actual status is clear from the description.

Summarising what described with reference to a dual insulation resistance 10, according to the invention it is possible to obtain an electric signal Icc indicative of the occurrence of a degradation of the resistance of the outer insulation layer 13 of such dual insulation resistance 10, as soon as such degradation occurs, by constantly applying a voltage differential between the outer 11 and inner 12 sheath of the same resistance 10.

In fact, with the indicated means, as soon as such degradation occurs, a short-circuit current Icc would be generated, capable of activating means suitable for disconnecting, either directly or indirectly, the supply of the same dual insulation resistance 10, wherein:
- the indirect disconnecting means are signallers 23 which cause the user's intervention;
- the direct disconnecting means are resistors R or optical insulators 26 or bistable relays 30 or equivalent thereof which disconnect the dual insulation resistance 10 from the mains,
and wherein the concurrent presence of both the indirect 23 and direct R, 26, 30 disconnecting means is possible but not essential, each of said means being per se apt to restore safety conditions.

It is preferable for the current generator 22 to be a battery since it is a simple device independent of the mains voltage. Moreover, the charge of such batteries is ensured for some years, as long as they are not used.

However, as said above, it is also possible to use a common low voltage transformer as current generator 22, which decreases the voltage of the current coming from the mains supply.

While the indicated signallers 23 activate under a voltage of just 2 - 3 V, it is preferable for the current generators 22 to use batteries from 3 to 24 V which can ensure such a charge capacity to keep signallers 23 active (whether they are LED or buzzers) for about a month, so as to alert the user upon his/her return even if he/she has been away for a long time.

In order to make the current generators 22 compatible with said signallers 23, it is suitable to provide calibration resistors 24 in said circuits 20.a, 20.b, 20.c, 20.d.

The electric power generated by the current generator 22 is sufficient, as is clear to a man skilled in the art, for activating the possible electro-mechanical or electronic thermal protector or the bistable relay 30 or coil 31. Other variants of the invention are possible without departing from the protection scope thereof.

The invention has been described with reference to a dual insulation resistance 10 but the teachings provided may be extended to multiple insulation resistances 10 with more than two insulating layers, where the outermost insulation layer 13 is confined between the outermost sheath 11 and the subsequent second one 12, whereas the innermost insulation layer 14 is confined between the resistive filament 15 and the innermost sheath 12. Of course, in a dual insulation resistance 10, as depicted, said second sheath 12 coincides with said innermost sheath 12.

Each of the insulating layers confined between two consecutive sheaths 11 and 12 may be individually monitored by a corresponding control device C or multiple consecutive layers confined by their outermost 11 and innermost 12 sheaths may be cumulatively monitored by a single control device C which, in this second case, would signal an anomaly only when all the enclosed insulating layers are deteriorated.

The advantages of the invention in terms of reliability and manufacturing simplicity are clear.

A further advantage is that mains disconnecting means of the multiple insulation 10 are possible, which can use any existing thermal protectors.

A further advantage is that the verification of the efficiency status of the device is obtained by pressing the test switch 21 with which an anomaly status is simulated which activates signaller 23.

## Claims

1. Device (C) for controlling the integrity of one or more insulating layers (13) of a multiple insulation resistance (10), wherein said one or more insulating layers (13) are consecutive layers (13) confined between their outermost (11) and the innermost (12) sheaths, **characterised in that**
it is provided with an electrical circuit (20.a; 20.b; 20.c; 20.d) having fixed connection points (A, B) with said outermost and innermost sheaths (11, 12) and, in series with said connection points (A, B),
- a current generator (22),
- disconnecting means (23; R; 26; 30) of the supply of said multiple insulation resistance (10),
wherein said current generator (22):
- constantly applies a voltage differential among said outermost (11) and the innermost (12) sheaths,
- is suitable for generating an electrical power and a short-circuit current (Icc) indicative of the occurrence of a degradation of the resistance of said outermost sheath (11), as soon as said degradation occurs,
- has voltage much weaker than hazardous value.

2. Control device (C) according to claim 1,
**characterised in that**
by said disconnecting means (23; R; 26; 30) it is meant indirect means (23) perceivable by a user, such as sound or visual signallers (23) which alert said user to disconnect said multiple insulation resistance (10) from the mains,
said short-circuit current (Icc) being sufficient for activating said indirect means (23).

3. Control device (C) according to claim 1,
**characterised in that**
by said disconnecting means (23; R; 26; 30) it is meant direct means (R; 26; 30) that directly disconnect said multiple insulation resistance (10) from the mains,
said short-circuit current (Icc) being sufficient for activating said direct means (R; 26; 30).

4. Control device (C) according to claim 1,
**characterised in that**
by said disconnecting means (23; R; 26; 30) it is meant direct means (R; 26; 30) that directly disconnect said multiple insulation resistance (10) from the mains and indirect means (23) perceivable by a user, such as sound or visual signallers (23) which alert said user to disconnect said multiple insulation resistance (10) from the mains, said short-circuit current (Icc) being sufficient for activating said direct means (23) and said indirect means (R; 26; 30).

5. Control device (C) according to any one of the previous claims,
**characterised in that**
said current generator (22) generates a voltage comprised between 2 and 24 V.

6. Control device (C) according to any one of the previous claims,
**characterised in that**
said current generator (22) is a battery (22).

7. Control device (C) according to any one of the previous claims except for 6,
**characterised in that**
said current generator (22) is a low voltage transformer for mains power supply.

8. Control device (C) according to any one of the previous claims except for 3,
**characterised in that**
said electrical circuit (20.a; 20.b; 20.c; 20.d) further comprises, in series with said indirect disconnecting means (23), resistors (24) for calibrating the short-circuit current (Icc) and the voltage drop allowed at the terminals of said signallers (23).

9. Control device (C) according to claim 8,
**characterised in that**
said signallers (23) are LED.

10. Control device (C) according to claim 8,
**characterised in that**
said signallers (23) are buzzers.

11. Control device (C) according to any one of the previous claims except for 3,
**characterised in that**
a testing switch (21) is provided, arranged so as to activate a signaller (23) aimed at checking the efficiency of said current generator (22) and/or the integrity of at least a portion of said electrical circuit (20.a; 20.b; 20.c; 20.d).

12. Control device (C) according to the previous claim,
**characterised in that**
said signaller (23) aimed at checking the efficiency of said current generator (22) and/or the integrity of at least a portion of said electrical circuit (20.a; 20.b; 20.c; 20.d) coincides with said indirect disconnecting means (23).

13. Control device (C) according to any one of the previous claims except for 2,
**characterised in that**
said direct disconnecting means (R; 26; 30) consist of one or more resistors (R) wherein the short-circuit current (Icc) circulates directly, and is generated due to the degradation of the dielectric power of said one or more consecutive insulating layers (13),
said one or more resistors (R) being suitable, when crossed by said short-circuit current (Icc), for heating the thermo-sensitive elements of an electromechanical thermal protector intended for controlling said multiple insulation resistance (10) up to the tripping of the same thermal protector.

14. Control device (C) according to any one of the previous claims from 1 to 12 except for 2,
**characterised in that**
said direct disconnecting means (R; 26; 30) consist of a transmission means (26) suitable for transmitting a signal to an electronic thermostat (T), intended for controlling said multiple insulation resistance (10), which causes the tripping of the thermal protector of said electronic thermostat (T), said signal being originated by the short-circuit current (Icc).

15. Control device (C) according to any one of the previous claims from 1 to 12 except for 2,
**characterised in that**
said transmission means (26) compatible with an electronic thermostat (T) consists in an optical insulator (26) in the LED whereof said short-circuit current (Icc) is made to circulate directly, in series with said LED of said optical insulator (26) there being provided a calibrating resistor (24).

16. Control device (C) according to any one of the previous claims from 1 to 12 except for 2,
**characterised in that**
said direct disconnecting means (R; 26; 30) consist of a bistable relay (30)
- with a first and a second coil (31, 32) capable of opening/closing a switch (33),
- with a reset switch (34) that closes said switch (33) energising said first coil (31),
- wherein the second coil (32) is capable of opening said switch (33),
- and wherein said short-circuit current (Icc) circulates in said second coil (32),
- and wherein said switch (33) opens at least one phase of said multiple insulation resistance (10).

17. Control device (C) according to the previous claim,
**characterised in that**
said switch (33) opens all the phases of said multiple insulation resistance (10).

18. Method for controlling the integrity of one or more insulating layers (13) of a multiple insulation resistance (10) by the control device (C) of claims 1 to 17, wherein said one or more insulating layers (13) are consecutive layers (13) confined between the outermost (11) and the innermost (12) sheaths thereof,
**characterised in that** it comprises the following steps:
- constantly applying a voltage in points (A, B) of said outermost and innermost sheaths (11, 12),
- using the short-circuit current (Icc) that is generated in the case of degradation of the dielectric power of said one or more consecutive insulating layers (13) for activating an alarm signal for the user and/or a device for disconnecting the supply of said multiple insulation resistance (10).

19. Method for controlling the integrity of one or more insulating layers (13) of a multiple insulation resistance (10) according to the previous claim,
**characterised in that**
it provides for a periodical check of the efficiency of devices (22) and electrical circuits (20.a; 20.b; 20.c; 20.d) implementing said method.

20. Method for controlling the integrity of one or more insulating layers (13) of a multiple insulation resistance (10) according to the previous claim,
**characterised in that**
such periodical check is carried out by artificially simulating a malfunction situation.

## Patentansprüche

1. Vorrichtung zur Kontrolle (C) der Integrität von einer oder mehreren Isolierschichten (13) eines Widerstands mit Mehrfachisolierung (10), wobei die eine oder mehreren Isolierschichten (13) aufeinanderfolgende Schichten (13) sind, die zwischen ihrer äußersten (11) und innersten Umhüllung (12) begrenzt sind,
**dadurch gekennzeichnet, dass**
sie einen elektrischen Stromkreis (20.a; 20.b; 20.c; 20.d) vorsieht, der feste Anschlusspunkte (A, B) an die äußerste und innerste Umhüllung (11, 12) und in Reihe mit den Anschlusspunkten (A, B) aufweist,
- einen Stromgenerator (22),
- Mittel zur Unterbrechung (23; R; 26; 30) der Stromversorgung des Widerstands mit Mehrfachisolierung (10),
wobei der Stromgenerator (22):
- ständig eine Spannungsdifferenz zwischen der äußersten (11) und innersten Umhüllung (12) anlegt,
- geeignet ist, eine elektrische Leistung und einen Kurzschlussstrom (Icc) zu erzeugen, der die erfolgte Verschlechterung des Widerstands der äußerste Umhüllung (11) anzeigt, sobald diese Verschlechterung eintritt,
- eine wesentlich niedrigere Spannung als die gefährlichen Werte aufweist.

2. Vorrichtung zur Kontrolle (C) nach Anspruch 1,
**dadurch gekennzeichnet, dass**
unter den Mitteln zur Unterbrechung (23; R; 26; 30) indirekte Mittel (23) verstanden werden, die von einem Benutzer wahrnehmbar sind, wie beispielsweise akustische oder visuelle Signalgeber (23), die den Benutzer warnen, den Widerstand mit Mehrfachisolierung (10) vom Netz zu nehmen,
wobei der Kurzschlussstrom (Icc) ausreichend ist, um diese indirekten Mittel (23) zu aktivieren.

3. Vorrichtung zur Kontrolle (C) nach Anspruch 1,
**dadurch gekennzeichnet, dass**
unter den Mitteln zur Unterbrechung (23; R; 26; 30) direkte Mittel (R; 26; 30) verstanden werden, die den Widerstand mit Mehrfachisolierung (10) direkt vom Netz nehmen,
wobei der Kurzschlussstrom (Icc) ausreichend ist, um die direkten Mittel (R; 26; 30) zu aktivieren.

4. Vorrichtung zur Kontrolle (C) nach Anspruch 1,
**dadurch gekennzeichnet, dass**
unter den Mitteln zur Unterbrechung (23; R; 26; 30) direkte Mittel (R; 26; 30), die den Widerstand mit Mehrfachisolierung (10) direkt vom Netz nehmen, und indirekte Mittel (23) verstanden werden, die von einem Benutzer wahrnehmbar sind, wie beispielsweise akustische oder visuelle Signalgeber (23), die den Benutzer warnen, den Widerstand mit Mehrfachisolierung (10) vom Netz zu nehmen,
wobei der Kurzschlussstrom (Icc) ausreichend ist, um die direkten Mittel (R; 26; 30) und die indirekten Mittel (23) zu aktivieren.

5. Vorrichtung zur Kontrolle (C) nach einem der vorhergehenden Ansprüche,
**dadurch gekennzeichnet, dass**
der Stromgenerator (22) eine Spannung erzeugt, die zwischen 2 und 24 V beträgt.

6. Vorrichtung zur Kontrolle (C) nach einem der vorhergehenden Ansprüche,
**dadurch gekennzeichnet, dass**
der Stromgenerator (22) eine Batterie (22) ist.

7. Vorrichtung zur Kontrolle (C) nach einem der vorhergehenden Ansprüche mit Ausnahme von Anspruch 6,
**dadurch gekennzeichnet, dass**
der Stromgenerator (22) ein Niederspannungstransformator für die Netzstromversorgung ist.

8. Vorrichtung zur Kontrolle (C) nach einem der vorhergehenden Ansprüche mit Ausnahme von Anspruch 3,
**dadurch gekennzeichnet, dass**
der elektrische Stromkreis (20.a; 20.b; 20.c; 20.d) ferner in Reihe mit den Mitteln zur indirekten Unterbrechung (23) Kalibrierwiderstände (24) des Kurzschlussstroms (Icc) und des Spannungsabfalls aufweist, die an den Anschlusspunkten der Signalgeber (23) zugelassen sind.

9. Vorrichtung zur Kontrolle (C) nach Anspruch 8,
**dadurch gekennzeichnet, dass**
die Signalgeber (23) LEDs sind.

10. Vorrichtung zur Kontrolle (C) nach Anspruch 8,
**dadurch gekennzeichnet, dass**
die Signalgeber (23) Summer sind.

11. Vorrichtung zur Kontrolle (C) nach einem der vorhergehenden Ansprüche mit Ausnahme von Anspruch 3,
**dadurch gekennzeichnet, dass**
ein Testschalter (21) vorgesehen ist, der derart angeordnet ist, um einen Signalgeber (23) zu aktivieren, der dazu bestimmt ist, die Effizienz des Stromgenerators (22) und/oder der Integrität von mindestens einem Teil des elektrischen Stromkreises (20.a; 20.b; 20.c; 20.d) zu überprüfen.

12. Vorrichtung zur Kontrolle (C) nach dem vorhergehenden Anspruch,
**dadurch gekennzeichnet, dass**
der Signalgeber (23), der dazu bestimmt ist, die Effizienz des Stromgenerators (22) und/oder der Integrität von mindestens einem Teil des elektrischen Stromkreises (20.a; 20.b; 20.c; 20.d) zu überprüfen, dem Mittel zur indirekten Unterbrechung (23) entspricht.

13. Vorrichtung zur Kontrolle (C) nach einem der vorhergehenden Ansprüche mit Ausnahme von Anspruch 2,
**dadurch gekennzeichnet, dass**
die Mittel zur direkten Unterbrechung (R; 26; 30) aus einem oder mehreren Widerständen (R) bestehen, in denen direkt der Kurzschlussstroms (Icc) fließt, der auf Grund der Verschlechterung der dielektrischen Leistung der einen oder mehreren aufeinanderfolgenden Isolierschichten (13) erzeugt wird,
wobei der eine oder die mehreren Widerstände (R) geeignet sind, wenn sie von dem Kurzschlussstrom (Icc) durchquert werden, die wärmeempfindlichen Elemente eines elektromechanischen Wärmeschutzes, der für die Kontrolle des Widerstands mit Mehrfachisolierung (10) bestimmt ist, bis zum Eingreifen des Wärmeschutzes selbst zu erwärmen.

14. Vorrichtung zur Kontrolle (C) nach einem der vorhergehenden Ansprüche 1 bis 12 mit Ausnahme von Anspruch 2,
**dadurch gekennzeichnet, dass**
die Mittel zur direkten Unterbrechung (R; 26; 30) aus einem Übertragungsmittel (26) bestehen, das geeignet ist, an ein elektronisches Thermostat (T), das für die Kontrolle des Widerstands mit Mehrfachisolierung (10) bestimmt ist, ein Signal zu übertragen, das das Eingreifen des Wärmeschutzes des elektronischen Thermostats (T) bewirkt, wobei das Signal von dem Kurzschlussstrom (Icc) erzeugt wird.

15. Vorrichtung zur Kontrolle (C) nach einem der vorhergehenden Ansprüche 1 bis 12 mit Ausnahme von Anspruch 2,
**dadurch gekennzeichnet, dass**
das Übertragungsmittel (26), das mit einem elektronischen Thermostat (T) kompatibel ist, aus einem Optoisolator (26) besteht, in dessen LED der Kurzschlussstrom (Icc) direkt fließen gelassen wird, wobei in Reihe mit dem LED des Optoisolators (26) ein Kalibrierwiderstand (24) vorgesehen ist.

16. Vorrichtung zur Kontrolle (C) nach einem der vorhergehenden Ansprüche 1 bis 12 mit Ausnahme von Anspruch 2,
**dadurch gekennzeichnet, dass**
die Mittel zur direkten Unterbrechung (R; 26; 30) aus einem bistabilen Relais (30) bestehen
- mit erster und zweiter Spule (31, 32), die geeignet sind, einen Schalter (33) zu öffnen/zu schließen,
- mit Rückstellschalter (34), der den Schalter (33) schließt, indem er die erste Spule (31) erregt,
- wobei die erste Spule (32) geeignet ist, den Schalter (33) zu öffnen
- und wobei der Kurzschlussstrom (Icc) in der zweiten Spule (32) fließt
- und wobei der Schalter (33) mindestens eine Phase des Widerstands mit Mehrfachisolierung (10) öffnet.

17. Vorrichtung zur Kontrolle (C) nach dem vorhergehenden Anspruch,
**dadurch gekennzeichnet, dass**
der Schalter (33) alle Phasen des Widerstands mit Mehrfachisolierung (10) öffnet.

18. Verfahren zur Kontrolle der Integrität von einer oder mehreren Isolierschichten (13) eines Widerstands mit Mehrfachisolierung (10) durch die Vorrichtung zur Kontrolle (C) der Ansprüche 1 bis 17, wobei die eine oder mehreren Isolierschichten (13) aufeinanderfolgende Schichten (13) sind, die zwischen ihrer äußersten (11) und innersten Umhüllung (12) begrenzt sind.
**dadurch gekennzeichnet, dass** es die folgenden Schritte aufweist:
- ständiges Anlegen einer Spannung an Punkten (A, B) der äußersten und innersten Umhüllung (11, 12),
- Verwenden des Kurzschlussstroms (Icc), der im Fall von der Verschlechterung der dielektrischen Leistung der einen oder mehreren aufeinanderfolgenden Isolierschichten (13) erzeugt wird, um ein Alarmsignal für den Benutzer und/oder eine Vorrichtung zur Unterbrechung der Stromversorgung des Widerstands mit Mehrfachisolierung (10) zu aktivieren.

19. Verfahren zur Kontrolle der Integrität von einer oder mehreren Isolierschichten (13) eines Widerstands mit Mehrfachisolierung (10) nach dem vorhergehenden Anspruch,
**dadurch gekennzeichnet,**
**dass** eine periodische Kontrolle der Effizienz der Vorrichtungen (22) und der elektrischen Stromkreise (20.a; 20.b; 20.c; 20.d) durchgeführt wird, die dieses Verfahren umsetzen.

20. Verfahren zur Kontrolle der Integrität von einer oder mehreren Isolierschichten (13) eines Widerstands mit Mehrfachisolierung (10) nach dem vorhergehenden Anspruch,
**dadurch gekennzeichnet, dass**
diese periodische Kontrolle durchgeführt wird, indem eine Anomaliesituation künstlich simuliert wird.

## Revendications

1. Dispositif pour contrôler (C) l'intégrité d'une ou plusieurs couches isolantes (13) d'une résistance d'isolation multiple (10), dans lequel lesdites une ou plusieurs couches isolantes (13) sont des couches consécutives (13) confinées entre leurs gaines la plus à l'extérieur (11) et la plus à l'intérieur (12),
**caractérisé en ce que**
il est muni d'un circuit électrique (20.a; 20.b; 20.c; 20d) ayant des points de connexion (A, B) fixes avec lesdites gaines la plus à l'extérieur et la plus à l'intérieur (11, 12) et, en série avec lesdits points de connexion (A, B),
- un générateur de courant (22),
- des moyens de déconnexion (23; R; 26; 30), de l'alimentation de ladite résistance d'isolation multiple (10),
dans lequel ledit générateur de courant (22):
- applique en permanence une différence de tension entre lesdites gaines la plus à l'extérieur (11) et la plus à l'intérieur (12),
- est apte à générer une puissance électrique et un courant de court-circuit (Icc) indicatif de l'apparition d'une dégradation de la résistance de ladite gaine la plus à l'extérieur (11), dès que ladite dégradation se produit,
- a la tension beaucoup plus faible que les valeurs dangereuses.

2. Dispositif de contrôle (C) selon la revendication 1,
**caractérisé en ce que**
par lesdits moyens de déconnexion (23; R; 26; 30), on entend des moyens indirects (23) perceptibles par un utilisateur, tels que des signaleurs (23) acoustiques ou visuels qui alertent ledit utilisateur de déconnecter ladite résistance d'isolation multiple (10) du réseau électrique,
ledit courant de court-circuit (Icc) étant suffisant pour activer lesdits moyens indirects (23).

3. Dispositif de contrôle (C) selon la revendication 1,
**caractérisé en ce que**
par lesdits moyens de déconnexion (23; R; 26; 30), on entend des moyens directs (R; 26; 30) qui, directement déconnectent ladite résistance d'isolation multiple (10) du réseau électrique,
ledit courant de court-circuit (Icc) étant suffisant pour activer lesdits moyens indirects (R; 26; 30).

4. Dispositif de contrôle (C) selon la revendication 1,
**caractérisé en ce que**
par lesdits moyens de déconnexion (23; R; 26; 30), on entend des moyens directs (R; 26; 30) qui, directement déconnectent ladite résistance d'isolation multiple (10) du réseau et des moyens indirects (23) perceptibles par un utilisateur, tels que des signaleurs (23) acoustiques ou visuels qui alertent ledit utilisateur de déconnecter ladite résistance d'isolation multiple (10) du réseau électrique, ledit courant de court-circuit (Icc) étant suffisant pour activer lesdits moyens directs (R; 26; 30) et lesdits moyens indirects (23).

5. Dispositif de contrôle (C) selon l'une quelconque des revendications précédentes,
**caractérisé en ce que**
ledit générateur de courant (22) génère une tension comprise entre 2 et 24 V.

6. Dispositif de contrôle (C) selon l'une quelconque des revendications précédentes,
**caractérisé en ce que**
ledit générateur de courant (22) est une batterie (22).

7. Dispositif de contrôle (C) selon l'une quelconque des revendications précédentes, à l'exception de la 6,
**caractérisé en ce que**
ledit générateur de courant (22) est un transformateur basse tension pour réseau électrique.

8. Dispositif de contrôle (C) selon l'une quelconque des revendications précédentes, à l'exception de la 3,
**caractérisé en ce que**
ledit circuit électrique (20.a ; 20.b; 20.c; 20.d) comprend en outre, en série avec lesdits moyens indirects de déconnexion (23), des résistances pour étalonner (24) le courant de court-circuit (Icc) et le la chute de tension autorisée aux bornes desdits signaleurs (23).

9. Dispositif de contrôle (C) selon la revendication 8,
**caractérisé en ce que**
lesdits signaleurs (23) sont des LED.

10. Dispositif de contrôle (C) selon la revendication 8,
**caractérisé en ce que**
lesdits signaleurs (23) sont des avertisseurs sonores.

11. Dispositif de contrôle (C) selon l'une quelconque des revendications précédentes, à l'exception de la 3,
**caractérisé en ce que**
un interrupteur d'essai (21) est prévu, agencé de manière à activer un signaleur (23) destiné à vérifier l'efficacité dudit générateur de courant (22) et / ou l'intégrité d'au moins une partie dudit circuit électrique (20.a; 20.b; 20.c; 20.d).

12. Dispositif de contrôle (C) selon la revendication précédente,
**caractérisé en ce que**
ledit signaleur (23) destiné à vérifier l'efficacité dudit générateur de courant (22) et / ou l'intégrité d'au moins une partie dudit circuit électrique (20.a; 20.b; 20.c; 20d) coïncide avec lesdits moyens indirects de déconnexion (23).

13. Dispositif de contrôle (C) selon l'une quelconque des revendications précédentes, à l'exception de la 2,
**caractérisé en ce que**
lesdits moyens de déconnexion directe (R; 26; 30) sont constitués d'une ou plusieurs résistances (R), dans lesquelles le courant de court-circuit (Icc) circule directement, et est généré en raison de la dégradation de la puissance diélectrique desdites une ou plusieurs couches isolantes consécutives (13),
lesdites une ou plusieurs résistances (R) étant adaptées, lorsqu'elles sont traversées par ledit courant de court-circuit (Icc), pour chauffer les éléments thermosensibles d'un dispositif de protection thermique électromécanique destiné à commander ladite résistance d'isolation multiple (10) jusqu'au déclenchement du protecteur thermique lui-même.

14. Dispositif de contrôle (C) selon l'une quelconque des revendications précédentes de 1 à 12 à l'exception de la 2,
**caractérisé en ce que**
lesdits moyens de déconnexion directe (R; 26; 30) sont constitués d'un moyen de transmission (26) apte à transmettre un signal à un thermostat électronique (T) destiné à commander ladite résistance d'isolation multiple (10), qui provoque le déclenchement du protecteur thermique dudit thermostat électronique (T), ledit signal étant émis par le courant de court-circuit (Icc).

15. Dispositif de contrôle (C) selon l'une quelconque des revendications précédentes de 1 à 12 à l'exception de la 2,
**caractérisé en ce que**
ledit moyen de transmission (26) compatible avec un thermostat électronique (T) consiste en un isolateur optique (26) dans laquelle LED on fait circuler directement ledit courant de court-circuit (Icc), en série avec ladite LED dudit isolateur optique (26) étant pourvu d'une résistance d'étalonnage (24).

16. Dispositif de contrôle (C) selon l'une quelconque des revendications précédentes de 1 à 12 à l'exception de la 2,
**caractérisé en ce que**
lesdits moyens de déconnexion directe (R; 26; 30) sont constitués par un relais bistable (30)
- avec une première et une seconde bobine (31, 32) aptes à ouvrir / fermer un interrupteur (33),
- avec un interrupteur de réarmement (34) qui ferme ledit interrupteur (33) en excitant ladite première bobine (31),
- dans lequel ladite seconde bobine (32) est apte à ouvrir ledit interrupteur (33),
- et dans lequel ledit courant de court-circuit (Icc) circule dans ladite seconde bobine (32),
- et dans lequel ledit interrupteur (33) ouvre au moins une phase de ladite résistance d'isolation multiple (10).

17. Dispositif de contrôle (C) selon la revendication précédente,
**caractérisé en ce que**
ledit interrupteur (33) ouvre toutes les phases de ladite résistance d'isolation multiple (10).

18. Procédé pour contrôler l'intégrité d'une ou plusieurs couches isolantes (13) d'une résistance d'isolation multiple (10), au moyen d'un dispositif de contrôle (C) selon les revendications 1 à 17, dans lequel lesdites une ou plusieurs couches isolantes (13) sont des couches consécutives (13) confinées entre leurs gaines la plus à l'extérieur (11) et la plus à l'intérieur (12),
**caractérisé en ce qu'**il comprend les étapes suivantes :
- appliquer une tension constante dans les points (A, B) desdites gaines la plus à l'extérieur et la plus à l'intérieur (11, 12),
- utiliser le courant de court-circuit (Icc) qui est généré dans le cas de la dégradation de la puissance diélectrique desdites une ou plusieurs couches isolantes successives (13) pour activer un signal d'alarme pour l'utilisateur et / ou un dispositif de coupure de l'alimentation de ladite résistance d'isolation multiple (10).

19. Procédé pour contrôler l'intégrité d'une ou plusieurs couches isolantes (13) d'une résistance d'isolation multiple (10) selon la revendication précédente,
**caractérisé en ce que**
il prévoit un contrôle périodique de l'efficacité des dispositifs (22) et des circuits électriques (20.a ; 20.b; 20.c; 20.d) mis en oeuvre dans ledit procédé.

20. Procédé pour contrôler l'intégrité d'une ou plusieurs couches isolantes (13) d'une résistance d'isolation multiple (10) selon la revendication précédente,
**caractérisé en ce que**
ce contrôle périodique est effectué en simulant artificiellement une situation de dysfonctionnement.
